Europäisches Patentamt

European Patent Office

Office européen des brevets

(19)

(11) Publication number: **0 211 609**
**A2**

(12)

# EUROPEAN PATENT APPLICATION

(21) Application number: **86305852.5**

(22) Date of filing: **30.07.86**

(51) Int. Cl.4: **H01L 21/78** , **H01L 23/28** , **G01N 27/46**

(30) Priority: **01.08.85 GB 8519373**

(43) Date of publication of application:
**25.02.87 Bulletin 87/09**

(84) Designated Contracting States:
**AT BE CH DE FR GB IT LI NL SE**

(71) Applicant: **UNILEVER PLC**
**Unilever House Blackfriars P.O. Box 68**
**London EC4P 4BQ(GB)**
Applicant: **UNILEVER NV**
**Burgemeester s'Jacobplein 1 P.O. Box 760**
**NL-3000 DK Rotterdam(NL)**

(72) Inventor: **Nylander, Claes Ivan**
**8 Colworth Road**
**Sharnbrook Bedford Mk44 1ET(GB)**
Inventor: **Shanks, Ian Alexander**
**56 The Bury**
**Pavenham Bedford MK43 7TY(GB)**

(74) Representative: **Stancliffe, Terence**
**Christopher et al**
**UNILEVER PLC Patents Division P.O. Box 68**
**Unilever House**
**London EC4P 4BQ(GB)**

(54) **Chemically sensitive semiconductor devices and their production.**

(57) A process for producing encapsulated semiconductor devices, which comprises using planar semiconductor-device-forming technique known per se to form a plurality of spaced semiconductor devices on a wafer, etching between the devices so formed, and passivating the etched array of devices, wherein:-

(a) the wafer is mounted on an inert solid sheet substrate;

(b) after application of the per se -known semiconductor-device-forming technique to the wafer, a selective etching process is applied to divide the mounted wafer into a plurality of separate portions of the wafer material carrying semiconductor devices, each portion mounted on the substrate;

(c) a passivating process is applied to the devices to cover them with passivating material and this is followed afterwards by etching to reveal locations for ohmic connections thereon; and

(d) the devices are then separated by cutting or breaking the substrate sheet into portions carrying semiconductor devices in which no part of the semiconductor-wafer materials (except ohmic contact locations) is left uncovered by passivating material.

## Chemically Sensitive Semiconductor devices and their production

### Field of Invention

This invention concerns chemically sensitive semiconductor devices, for example chemically-sensitive FET transducers (transistors), often called chemfets, and their production, and in particular to methods of encapsulating such devices.

### Background to the invention

Manufacture of chemfets is well documented in the literature. As an example, reference is made to US Patent No. 4 020 830. Such devices essentially comprise a field effect transistor formed in a manner known per se by a semi-conductor substrate material having a certain doping polarity with a pair of spaced-apart diffusion regions located at the surface of the substrate having an opposite doping polarity to that of the substrate, with a layer of electrically insulating material overlying the diffusion regions and the substrate surface therebetween. Chemical sensitivity or selectivity can be achieved by means of a second overlying layer of material having the property of interacting with one or more substances so as to modulate the electric field between the two diffusion regions which exists when the device is connected to an appropriate source of emf. The modulation is dependent on the chemical properties of the substance and allows a measure of those properties to be made.

According to the choice of overlying layer, so measurements on inter alia ion activity, immuno-chemical concentration, reducible gas concentration and enzyme concentration may in principle be made.

Such devices can be made to a very small scale, thereby allowing them to be an integral part of probes which can be inserted into animals or humans for in vivo detection, measurement and monitoring of chemical properties within the body.

It is a problem with such devices that the substrate from which field effect transistors are made, which is almost always a silicon crystal, should not be allowed to come in direct electrical or chemical contact with the fluids which are to be measured, to avoid its degradation and corrosion. Accordingly, passivating coatings such as silicon nitride are applied as part of the semiconductor process. For economic reasons, field effect transistors are made in large quantities on each silicon crystal wafer, and after the processing has been finished the wafer is cut into small units. This has the result that the silicon material at the edges of each unit becomes exposed. It therefore becomes desirable to encapsulate such exposed edges also. But this is not achieved, or at least not easily achieved, using known semiconductor techniques. In the past, polymers such as epoxy or polyimide have been applied to encapsulate individual devices.

It is known to encapsulate a chemically sensitive FET transducer with a material which is essentially chemically inactive with respect to the fluids to which the device is to be exposed, and also essentially impervious to such fluids.

Whilst small quantity production is possible under laboratory conditions, the construction of such devices on a mass production basis has so far proved difficult to achieve economically.

GB 2 010 011 (Kuraray) describes formation of arrays of chemfets by silicon planar technique, followed by etching the chip and by silicon nitride formation to leave a construction of comb-like shape, with a row of needle-like chemfet devices which project from a common semiconductor wafer backbone. A silicon nitride coating is applied to completely cover a plurality of the needle like devices formed in the wafer of substrate, and the only unprotected surface of each needle is then that left after each needle is cut or broken away from the remainder of the wafer. By embedding this unprotected end together with the ohmic connections to the device, in an encapsulating support of suitably chemically inactive and electrically insulating impervious material, so total protection is possible. However, the needle-like devices are specialised and the process of fabricating them is complex and non-standard. The semiconductor-device-forming process required by GB 2 010 011 also departs in significant respects from current standard planar semi-conductor-device manufacturing technique, and is correspondingly costly.

As an alternative it has also been proposed to use the currently available commercial technique of forming silicon fet devices on a sapphire substrate and to encapsulate the resulting device with silicon nitride. Reference is made to an article entitled "NEC Develops Bio-Sensor Device with Enzyme Membrane Process" in the Journal of Electronic Engineering, October 1984, pages 20 to 21. This technique is, however, more expensive than ordinary techniques and is used mainly for special applications.

Summary of the invention

It is an aim of the present invention to provide a method for encapsulating semiconductor devices such as chemfets which is easily adaptable to standard so-called bulk-silicon fabrication techniques, and to carry out bulk encapsulation of the devices in a convenient manner.

The present invention also aims to provide a technique to enable chemically sensitive semiconductor devices to be produced in a form which shows full protection against corrosion before it is mounted in sealing material.

The present invention also aims to provide chemically sensitive field effect devices which can be made by standard planar semiconductor technique, i.e. by production in a 2-dimensional array which is exposed to layer-forming and etching treatments from one side only.

According to an aspect of the invention we provide a process for producing encapsulated semiconductor devices, especially for example semiconductor devices which are or are to be made chemically sensitive, which comprises using planar semiconductor-forming technique known per se to form a plurality of spaced semiconductor devices, e.g. chemically sensitive field-effect transistors, on a wafer, etching between the devices so formed, and passivating the etched array of devices, (i.e. rendering them protected from corrosion etc. by means of a layer of protective material), characterised in that the wafer is mounted on an inert solid sheet substrate; in that after application of the per se known semiconductor-device-forming technique to the wafer, a selective etching process is applied, to divide the mounted wafer into a plurality of separate portions of the wafer material carrying semiconductor devices, each portion mounted on the (for example ceramic) substrate; in that a passivating process is applied to the devices to cover them with passivating material and this is followed afterwards by etching to reveal locations for ohmic connections thereon; and in that the devices are then separated by cutting or breaking the substrate sheet into portions carrying (e.g. chemically sensitive) semiconductor devices in which no part of the semiconductor-wafer materials (except ohmic contact locations) is left uncovered by passivating material.

Also provided according to an aspect of the present invention is a method of encapsulating chemically sensitive semiconductor devices such as FET transducers formed on a silicon wafer, comprising the steps of:

1) coating the entire wafer with silicon nitride or aluminium oxide or other passivating material using for example an LPCVD or plasma CVD process,

2) mounting the coated wafer on a ceramic or other suitable substrate to form an assembly, using an adhesive material capable of withstanding subsequent coating and etching processes,

3) using (e.g. conventional) photo lithographic techniques and chemical etching, removing the layer of silicon nitride and, in an appropriate case, any other passivating material, from regions surrounding the transducers or other devices leaving islands of silicon nitride and/or other passivating material over the transducers or other device,

4) similarly removing the semiconductor (e.g. silicon) wafer material left exposed by the removal of the silicon nitride and/or other passivating material in the preceding step,

5) depositing a further layer of silicon nitride and/or other passivating material over the entire surface of the assembly thereby to cover any exposed semiconductor, e.g. silicon, and previous passivating (e.g. silicon nitride) layers which remain,

6) applying a photo-resist, exposing and etching (e.g. using conventional techniques), to remove passivating material, e.g. silicon nitride, in those regions where ohmic connections are to be made to the devices, e.g. fet transducers, (and in certain cases also to remove part of the thickness of passivating material overlying the gate regions of the devices),

7) depositing conductive material to form the said ohmic connections (if not already present) by - (e.g. conventional) photo lithographic technique and chemical etching, and

8) cutting or otherwise separating the assembly into individual units each containing at least one semiconductor device.

Also provided as another aspect of the invention are arrays of semiconductor devices, and the individual devices obtained by separation from such arrays, said arrays comprising devices in the form of mesas mounted on the surface of an inert carrier substrate, said array having been formed by etching a semiconductor wafer carrying said devices so as to sever said wafer completely thereby to leave said mounted devices in the form of mesas, wherein passivating material covers all the surfaces of the semiconductor material forming said devices except for ohmic locations.

In many cases, the ohmic connections of devices so formed are afterwards embedded in suitable sealing material such as for example epoxy resin.

A unit constructed in accordance with the methods described herein can be wholly encapsulated within silicon nitride or other passivating material except where ohmic connections are to be made thereto, and the latter can be encapsulated, for example, within a supporting structure for the unit. made of chemically inactive and electrically insulating material and fitted around the unit (for example, around one end of the unit, covering the ohmic connections) after the ohmic connections have been made.

It is often desirable for the ohmic connections to the unit to be distant from the chemically sensitive region of the unit. In this event, conductive tracks or other conductive means can advantageously be incorporated into the formation of the transducer, to permit the remote location of the ohmic connections, and these conductive tracks or other means can be thereby automatically encapsulated by the process described herein.

In addition or alternatively it is often desirable to provide a form of device with a configuration that removes the chemically sensitive region of the unit away from the transistor region on the wafer, and to a remote location. To this end, conventional field effect transistors can be formed on the silicon wafer and the gate electrodes of these transistors maintained at the same potential as a remotely located sensing electrode by means of, for example, conductive tracks or other conductive means which are incorporated into the formation of the transducers prior to the encapsulation steps.

The conductive tracks may themselves comprise the sensing electrodes and in that event it is merely necessary to form a window in the silicon nitride in the same manner as for the windows for the ohmic connections and to cover the exposed track with a suitable membrane material, for example an ion selective PVC layer.

Alternatively, where the material forming the conductive track is not suitable to form the sensing electrode, a window may nevertheless be formed at the place where the electrode is required, and an appropriate electrode material may be deposited by any convenient process during or after the encapsulated process, after which the electrode material is covered with a suitable membrane material as aforesaid.

A pseudo reference electrode, typically of gold or platinum, may be formed by vacuum deposition, screen printing or otherwise, for example on the underside of the insulating ceramic substrate before the assembly is cut, so that each unit includes the pseudo reference electrode on its underside. Alternatively, such a further electrode may be located on any accessible and convenient surface of the unit.

In the practice of this invention, the inert solid sheet substrate may be selected from any suitable materials on which semiconductor wafers can be mounted (e.g. with epoxy resin fixative), and which can be broken or cut into portions: especially for example ceramic or plastics material, or glass or metal substrates. Usually insulating substrates are preferred. Examples of specific preferred materials are ceramic sheet such as conventionally used in the fabrication of hybrid electronic circuitry, and polyimide sheets, e.g. "Kapton" film (Trade Mark: obtainable from DuPont). Substrate thickness can for example be suitably of the order of about 1 to 2 mm. Suitable temperature constraints should also be observed in connection with the adhesives (e.g. epoxy resins) used to fix the wafers to the inert substrates.

Suitable passivating or protective materials are for example silicon nitride, aluminium oxide and tantalum oxide, as well as plastics materials such as polyimide, especially for example in respect of outer layers of passivating material, in examples as described below. It can be important that a thin layer of silicon nitride, aluminium oxide or tantalum oxide alone overlies the channel (gate) region of a device as discussed herein.

In one type of embodiment of the present invention, a semiconductor wafer can be taken, on which an array of semiconductor devices (e.g. chemically sensitive fets) has been formed, and coated overall with passivating material such as silicon nitride. Such a wafer can be mounted on a substrate sheet as described herein, and the process of etching the wafer to form a plurality of islands on the substrate sheet, and of passivating all exposed surfaces, carried out with incidents as described elsewhere herein.

In another type of embodiment of the invention, a semiconductor wafer can be mounted on a substrate sheet and all of the processes of device-formation and etching carried out on the wafer in its mounted condition.

The type of planar process to be used is chosen to match the stability (especially to high temperature) of the substrate and other materials used. For example, when the substrate is a ceramic sheet, low-pressure chemical vapour deposition (up to about 900°C) or plasma chemical vapour deposition (up to about 300°C) can be used. When plastics substrate is used, suitable low temperature technique is much preferred When plastics passivating layer material, e.g. polyimide, is used, it can be applied by spraying or dipcoating a preparation of the material in a flowable form, e.g. diluted by a suitable solvent or extender.

The invention is further described, by way of non-limitative example, with reference to the accompanying drawings (not to scale), in which:

Figure 1 is a perspective view of a processed silicon wafer having field effect devices formed therein;

Figure 2 illustrates the various steps in a method according to an embodiment of one aspect of the invention, for encapsulating the devices; and

Figure 3 is a perspective view of a device encapsulated in accordance with the above method illustrated in Figure 2.

Figure 4 illustrates the various steps in a further variant method according to an embodiment of the invention.

The Figures are not to scale: as a general guide to dimensions, it can be said that substrates as used herein can usually be of the order of about 1-3 mm thick, e.g. about 2 mm; silicon wafer material can usually be of the order of about 0.1-0.3 mm thick, e.g. about 0.2 mm thick; and the various passivating layers can each usually be of the order of about 0.1 to 10 micron thick, e.g. of the order of about 0.1 micron if silicon nitride is used.

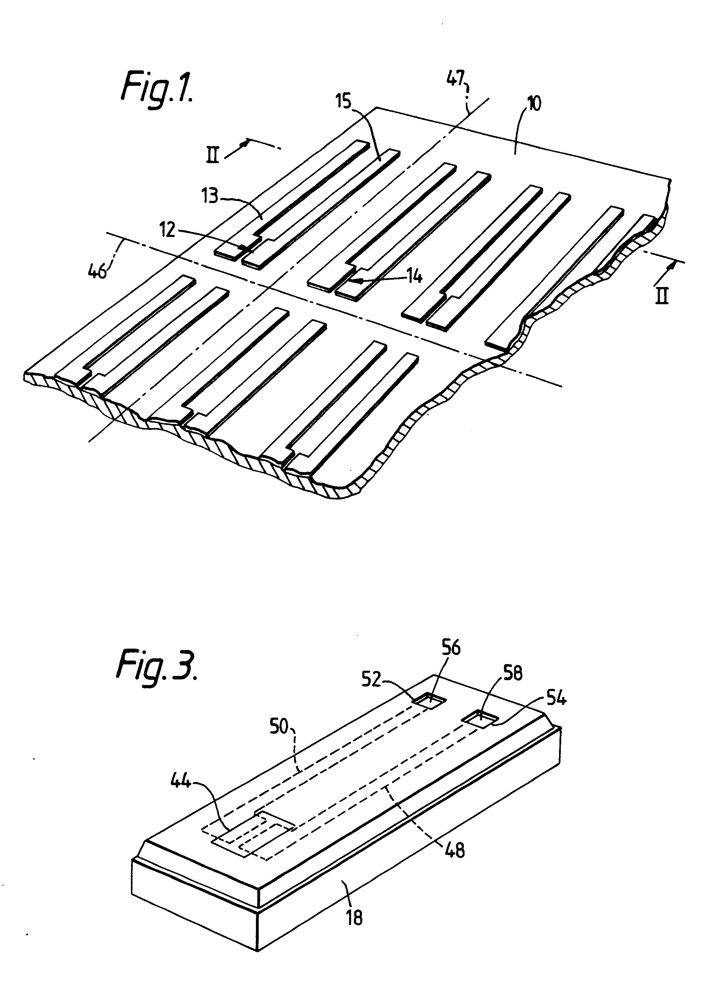

Figure 1 shows the corner of a processed wafer 10 of silicon having formed therein (using convention photo lithographic or chemical etching techniques) a regular array (which in this example consists of n-type zones), each pair of zones such as 13 and 15 (another such pair is shown at 17,19) defining the source and drain respectively of a field effect transducer (transistor) and leaving channels such as 12 and 14 between the source and drain connections of the several devices.

Figure 2a is a cross section on the line II.II of Figure 1.

Figures 2b to 2g shown by way of similar cross sections on the line II.II of how the different steps of the encapsulation process of the invention can be achieved.

In the first place the wafer is coated completely with silicon nitride as shown in Figure 2b. The silicon nitride coating is denoted by reference to numeral 16.

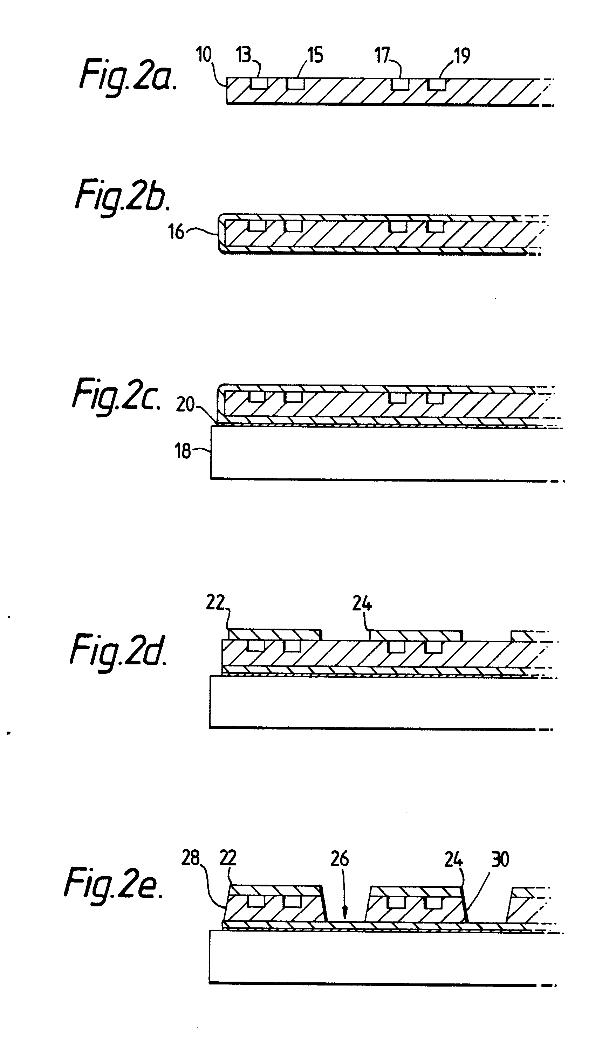

The coated wafer is then located on a substrate of ceramic material 18 and secured in place by a film of adhesive 20 as shown in Figure 2c.

Using conventional masking and etching techniques, the silicon nitride is selectively etched away except over the n-type regions and the elongate tracks leading thereto such as 13, 15 and 17, 19, i.e. the silicon nitride overlying each device as a whole is left in place, and the silicon nitride between devices is etched away. The resulting elongate islands of silicon nitride, overlying the n-type material in the silicon wafer surface, are denoted by reference numerals 22 and 24 in Figure 2d.

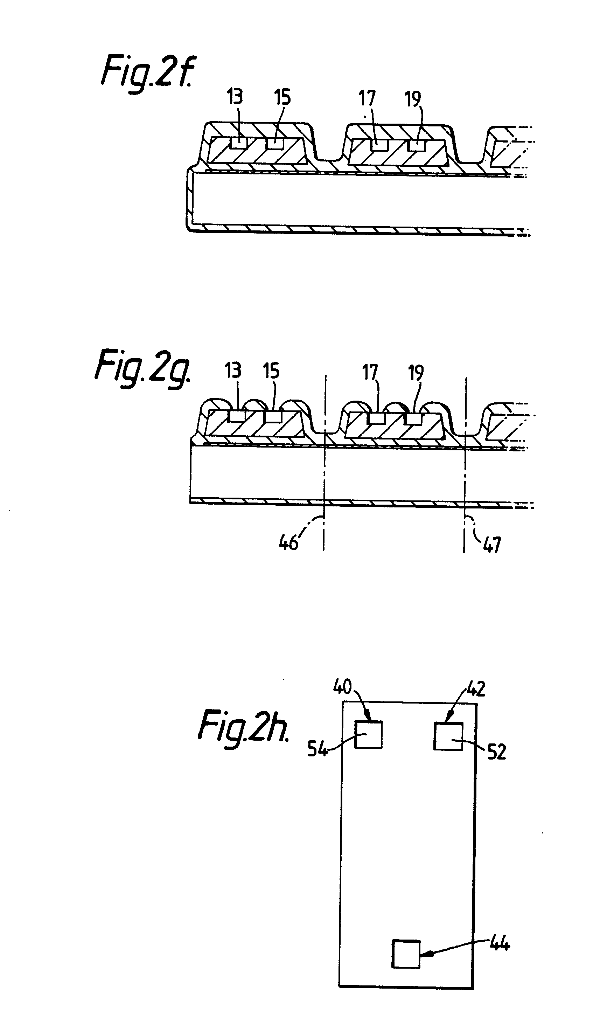

Using a further (e.g. similar) etching process, the silicon between the two islands 22 and 24 is also removed so as to leave a channel 26 containing no silicon between the two islands of silicon nitride coated silicon. Silicon below the covering 22 is denoted by reference numeral 28 and that below the coating 24 by reference to numeral 30, as can be seen in Figure 2e. The assembly is then recoated overall with silicon nitride. It can be seen that this results in particular in a double thickness of silicon nitride over the n-type regions 13, 15 and 17, 19 (in other words, over each chemfet device) as shown in Figure 2f.

Using conventional masking and etching techniques, regions of the silicon nitride coating are removed so as to leave parts of the conductive tracks 13, 15 and 17, 19 exposed for establishing ohmic connections to the transducer, as shown in Figure 2g.

If desired, and in order to confer (in known manner) appropriate chemical selectivity on the resulting device, a selective (e.g. ion-selective) barrier in the form of a thin film is deposited over the material of the fet channel, shown in the drawing as a narrow isthmus of p-type material located between the two n-type regions. Ion diffusion into or through the selective barrier causes changes in the electric field in the channel region in manner known per se. The devices may under certain conditions be used for some chemical measurements (e.g. pH measurement) even without such films.

Figure 2h shows in plan view the finished transducer unit with two windows 40, 42 through which electrical connections can be made to the two n-type regions. The applied film of selective barrier material, through which chemical diffusion is to occur during use of the device, is (where present) denoted by reference numeral 44.

The transducer unit shown in Figure 2h is formed by cutting the substrate 18 after encapsulation, along the lines 46 and 47, to remove the unit from the remainder of the array of units.

It will be seen that even after cutting, no silicon is exposed.

In a variant of the process illustrated in Figure 2, the overall passivating layer applied in Figure 2f may be different from the initial layer 16 immediately overlying the semiconductor: this makes it possible, at the stage shown by Figure 2g, to carry out a controlled reduction of the passive layer thickness overlying the channel regions by a suitable further etching of defined areas of the outermost layer of passivating material. This can enhance the sensitivity and stability of the final product.

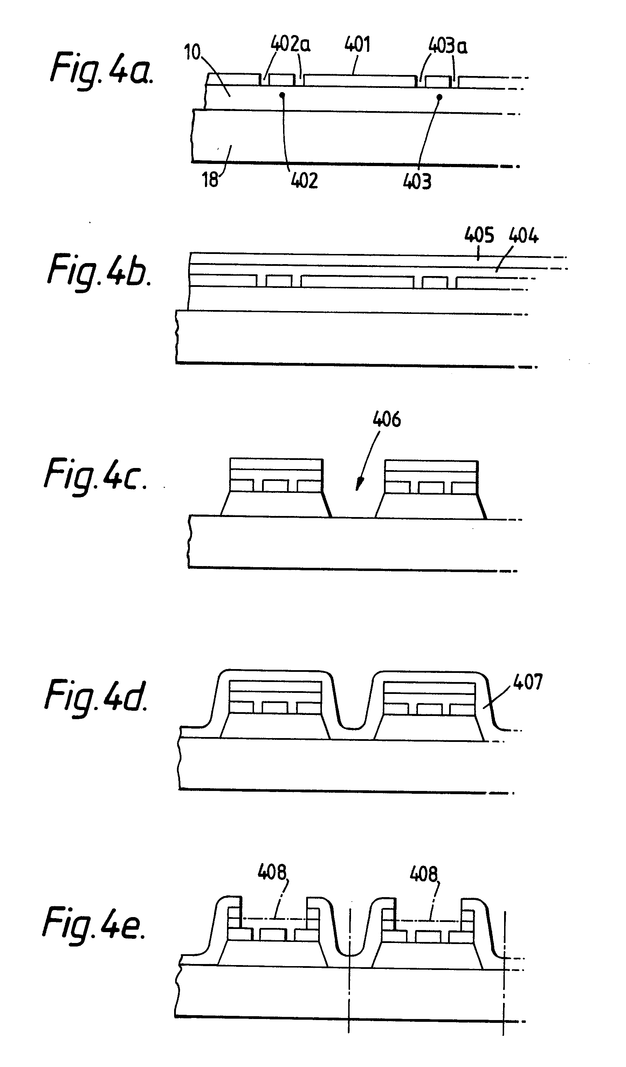

Figure 3 illustrates in a perspective view the unit of Figure 2h in which the electrical connection to the two n-type regions of the transducer unit is effected by means of conductive tracks, formed in the surface of the silicon wafer so that ohmic connections to the source and drain regions can be effected remote therefrom. In the example of Figure 3, the conductive tracks are integral extensions of the source and drain regions themselves. To this end the conductive tracks are shown in dotted outline at 48 and 50. Conductive connection pads are denoted by reference to numerals 52 and 54 respectively. Conductors 56 and 58 are connected as by soldering to the pads 42, 54 to enable connection of the transducer into an electrical circuit.

In the transducer shown in Figure 3, the film of selective barrier material 44 is applied to the surface of the silicon nitride coating above the gap between the two regions of N-type material, forming the source and drain of the transducer.

Figures 4a-4e shown in schematic and diagrammatic cross-section the course of a manufacturing process according to another embodiment of the invention.

The stage represented by Figure 4a is somewhat analogous to that shown in Figure 2c, in the earlier-described embodiment. Wafer 10 and substrate 18 correspond: adhesive is not shown, and also not shown in the drawing is an overall passivating layer corresponding to layer 16 in Figure 2. An upper passivating layer is shown as 401, with two pairs of etched apertures 402a, 403a, each pair corresponding to locations for ohmic connections to source and drain respectively of a single field-effect device. An array of field-effect devices has been formed in wafer 10: the several diffusion regions are not separately shown, but the locations of two such devices of the array are generally shown at 402, 403.

Substrate 18 can be ceramic, wafer 10 can be silicon and passivating layer 401 can be silicon nitride.

Figure 4b shows a development of the stage of Figure 4a, after the application of two further unlike passivating layers 402 and 403, usefully for example silicon oxide and silicon nitride respectively. One significant matter in this embodiment is to ensure that layers 401 and 402 are of unlike material so that in a later stage, after formation of the isolated "mesas" of semiconductor on the inert substrate, (as in Figures 4c-4e) an etching operation which can be of low geometrical precision can be applied to reveal again the locations for ohmic connections 402a, 403a without significantly etching the silicon nitride layer 401 which was etched in a high-precision stage (before Figure 4a) to define those locations in the first place.

After formation of layers 404, 405, a deep etch of areas between the several devices on wafer 10 is performed, so as to sever wafer 10 through its entire depth into an array of separated "mesas" of wafer material carrying the previously-formed semiconductor devices still bonded to substrate 18 - (Figure 4c). This etching operation may be carried out in stages using different etch reagents, corresponding to the nature of layers 401, 404, 405, etc. to be etched. After this stage, a further overall passivating layer 407 is applied to a sufficient thickness to act if needed as primary encapsulant for the finished devices (Figure 4d).

Finally (see Figure 4e) a photoresist/etch process, e.g. employing dip-coating of the photoresist, with two etch stages to correspond with the differing nature of the materials to be etched, is applied to the result of Figure 4d, to reveal again the contact locations for ohmic connections, which may (or alternatively may not) already have been provided with ohmic contact material. The first stage of the etch removes areas of layers 405 and 407 - (e.g. silicon nitride) (see Figures 4b and 4d) down to level 408. The second etch stage removes the underlying defined area of layer 404 (e.g. silicon oxide) to reveal locations for the ohmic contacts as defined by layer 401, which is of a material (e.g. silicon nitride) not substantially etched by the etchant for layer 404 (e.g. of silicon oxide). This enables the contact locations to be revealed by an etching process which does not have to be applied with the same full precision relative to the locations of the semiconductor devices beneath the passivating layers, as the precision that is necessary to define the contact apertures in the lowermost passivating layer itself. Such precision would be less convenient to achieve in respect of profiles which depart as far from the flat as do the "mesa" forms of Figures 4c to 4e.

Finally the product of Figure 4e is cut or broken between devices along the dotted lines indicated, and the individual devices provided with connections to external circuitry in known manner before use.

It is however not essential in embodiments like Figure 4 to have the apertures 402a, 403a defined and open at the stage of Figure 4a. If desired, a further precision etching of such apertures can be carried out after a stage corresponding (otherwise) to Figure 4e.

In a further variant of the procedure according to Figures 4a-4e, in which the overall passivator layer 407 differs in nature from layer 401 (e.g. with a nitride layer 401 and polyimide layer 407), it is possible to reveal the ohmic contact locations after stage 4c by etching layers 405 and 404 successively, and then afterwards to apply an overall layer corresponding to 407, and to remove parts of this layer again from defined areas encompassing the ohmic connection locations as well as the channel regions of the individual devices, by analogy with the areas shown as newly etched in Figure 4e.

In certain embodiments, substrate 18 and overall passivating layer 407 can be of polyimide. Polyimide can be applied as a passivating layer in solvent-diluted form.

Devices made as described herein can be further treated and used in many of the ways previously proposed in respect of chemically-sensitive semiconductor devices such as field effect transistors.

The present invention is susceptible to many modifications and variations as will be apparent to the skilled reader, and this disclosure extends to the use of all combinations and subcombinations of the features described hereinabove and in the accompanying drawings.

## Claims

1. A process for producing encapsulated semiconductor devices, which comprises using planar semiconductor-device-forming technique known per se to form a plurality of spaced semiconductor devices on a wafer, etching between the devices so formed, and passivating the etched array of devices, wherein:-

(a) the wafer is mounted on an inert solid sheet substrate;

(b) after application of the per se -known semiconductor-device-forming technique to the wafer, a selective etching process is applied to divide the mounted wafer into a plurality of separate portions of the wafer material carrying semiconductor devices, each portion mounted on the substrate;

(c) a passivating process is applied to the devices to cover them with passivating material and this is followed afterwards by etching to reveal locations for ohmic connections thereon; and

(d) the devices are then separated by cutting or breaking the substrate sheet into portions carrying semiconductor devices in which no part of the semiconductor-wafer materials (except ohmic contact locations) is left uncovered by passivating material.

2. A process according to claim 1, wherein the semiconductor-device-forming technique in step - (b) is applied after the wafer is mounted on the substrate.

3. A process according to claim 1, wherein a wafer carrying semiconductor devices formed thereon is mounted on the substrate.

4. A process according to claim 1, 2 or 3 wherein the substrate is of ceramic sheet material.

5. A process according to claim 1, 2 or 3 wherein the substrate is of plastics material.

6. A process according to claim 1, comprising the steps of:

1) coating a semiconductor wafer carrying an array of semiconductor devices thereon, with passivating material,

2) mounting the coated wafer on a substrate to form an assembly, using an adhesive capable of withstanding subsequent coating and etching processes,

3) using photolithographic techniques and chemical etching, removing the layer of passivating material from regions surrounding the devices leaving islands of passivating material over said devices,

4) similarly removing the semiconductor wafer material left exposed by the removal of the passivating material in step (3),

5) depositing a further layer of passivating material over the entire surface of the assembly thereby to cover any exposed semiconductor and previous passivating layers which remain,

6) applying a photoresist, exposing and etching to remove passivating material in those regions where ohmic connections are to be made to the devices,

7) depositing conductive material to form the said ohmic connections (if not already present) by photolithographic technique and chemical etching, and

8) cutting or otherwise separating the assembly into individual units each containing at least one semiconductor device.

7. A process according to claim 6, wherein the wafer is of silicon, carrying chemically sensitive fet devices thereon, the substrate is of ceramic, and the passivating material comprises silicon nitride.

8. An array of semiconductor devices comprising devices in the form of mesas mounted on the surface of an inert carrier substrate, said array having been formed by etching a semiconductor wafer carrying said devices so as to sever said wafer completely thereby to leave said mounted devices in the form of mesas, wherein passivating material covers all the surfaces of the semiconductor material forming said devices except for ohmic locations.

9. Processes according to claim 1, and device arrays and their derivatives as claimed in claim 8, comprising any one or more of the several features of the foregoing description and drawings.

**Fig.1.**

**Fig.3.**

*Fig.2a.*

*Fig.2b.*

*Fig.2c.*

*Fig.2d.*

*Fig.2e.*

*Fig.2f.*

13  15    17  19

*Fig.2g.*

13  15    17  19

46    47

*Fig.2h.*

40    42

54    52

44

0 211 609

Fig.4a.

Fig.4b.

Fig.4c.

Fig.4d.

Fig.4e.